# EUROPEAN PATENT SPECIFICATION

(11) **EP 3 304 548 B1**
(45) Date of publication and mention of the grant of the patent: **26.02.2020**
(21) Application number: 16848782.5
(22) Date of filing: 22.07.2016
(51) Int. Cl.: G10L 21/0208, G10L 21/02, H04R 3/00, H04R 3/02, H04R 3/04, H03G 3/30, G10L 21/0216, G10L 21/034, G10L 21/0364, H04R 27/00, H04S 3/00

(54) **ELECTRONIC DEVICE AND METHOD OF AUDIO PROCESSING THEREOF**
ELEKTRONISCHE VORRICHTUNG UND VERFAHREN ZUR TONVERARBEITUNG DAVON
DISPOSITIF ÉLECTRONIQUE ET SON PROCÉDÉ DE TRAITEMENT AUDIO

(30) Priority: 23.09.2015 KR 20150134403
(43) Date of publication of application: 11.04.2018
(73) Proprietor: Samsung Electronics Co., Ltd., Suwon-si, Gyeonggi-do 16677 (KR)
(72) Inventor: KIM, Dong-wan, Seoul 06798 (KR); SONG, Myung-suk, Seoul 05382 (KR)
(74) Representative: Appleyard Lees IP LLP
(86) International application number: PCT/KR2016/007980
(87) International publication number: WO 2017/052056

(56) References cited:
- WO-A2-2008/041878
- JP-A- 2008 141 718
- KR-A- 20110 010 179
- KR-B1- 100 630 826
- US-A1- 2008 085 014
- US-A1- 2010 062 713
- US-A1- 2011 178 798
- US-A1- 2012 189 147
- US-A1- 2012 249 785
- US-A1- 2013 202 130
- US-A1- 2014 126 745
- US-A1- 2014 286 497

## Description

### [Technical Field]

Apparatuses and methods consistent with the present disclosure relate to an electronic device and an audio processing method thereof, and more particularly, to an electronic device configured to process an audio signal output from a microphone, and an audio processing method thereof.

### [Background Art]

Recently, various types of electronic devices are being developed and distributed. Especially, various electronic devices and infrastructure for processing voice signals of telephone calls, video conferences, voice recognition and the like have been commercialized.

In order to facilitate telephone calls and voice recognition, effective audio processing systems are required. Generally, an audio processing system performs operations of removing noise and the like from audio signals being output from a microphone.

Most audio processing systems initially set various parameter values that determine its performance and then perform signal processing operations. For example, an electronic device equipped with a voice recognition system analyzes the surrounding acoustic environment and initializes certain filter values at a certain cycle when performing an initial setting operation.

In such a case, any changes in the surrounding acoustic environment cannot be reflected in the operations of the audio processing system, and thus, in certain acoustic environments, the performance of the audio processing system deteriorates.

Therefore, there is a need to develop a technique that could reflect changing acoustic environment to effectively process audio signals.

Patent publication US 2011/0178798 A1 relates to adaptive ambient sound suppression and speech tracking. Patent publication US 2014/0126745 A1 discloses a combined suppression of noise, echo, and out-of-location signals. Patent publication US 2013/0202130 A1 discloses apparatuses for, and methods of, compensating for distance and velocity present between a microphone and user's mouth. Patent publication US 2012/0189147 A1 relates to a sound processing apparatus, sound processing method and hearing aid. Patent publication US 2008/0085014 A1 discloses a gain adjusting system for adjusting a gain of a sound signal in an audio system. Patent publication WO 2008/041878 A2 discloses a system and procedure of free speech communication using a microphone array.

### [Disclosure]

### [Technical Problem]

Exemplary embodiments provide an electronic device that processes an audio signal dynamically according to the acoustic environment surrounding the electronic device, and an audio signal processing method thereof.

### [Technical Solution]

According to an aspect of an exemplary embodiment, there is provided an electronic device as set out in the accompanying claim 1.

The processor may determine the first information based on an energy level computed for each speaker signal, and determines the second information using a phase difference between multiple audio signals.

The signal processor may include a noise collector configured to perform beam-forming on the at least one audio signal, and the processor may control the noise canceller to change a beam-forming direction according to the second information.

The signal processor may include a signal amplifier configured to amplify the at least one audio signal, and the processor controls the signal amplifier to change an extent of amplification of the at least one audio signal according to a distance to the sound source.

The processor determines the first and second information by analyzing the speaker input signal and the at least one audio signal in a predetermined number of frame units.

The first information may include at least one of information regarding whether there is output from the speaker, information regarding a number of channels, volume information, and linearity information regarding a transfer function of the speaker and the microphone, and the second information may include at least one of information regarding a number of the sound source, direction information and information regarding a distance to the sound source.

According to an aspect of another exemplary embodiment, there is provided an audio processing method of an electronic device equipped with at least one speaker and at least one microphone, the method as set out in the accompanying claim 9.

The determining may include: determining the first information based on an energy level of the at least one speaker input signal; and determining the second information using a phase difference between multiple audio signals.

The processing may include: changing a beam-forming direction according to the second information regarding the sound source.

The processing may include changing an extent of amplification of the at least one audio signal according to a distance to the sound source.

The determining may include determining the first and second information by analyzing the speaker input signal and the at least one audio signal in a predetermined number of frame units.

The first information may include at least one of information regarding whether there is output from speaker, information regarding a number of channels, volume information, and linearity information regarding a transfer function of the speaker and the microphone, and the second information may include at least one of information regarding a number of the sound source, direction information and information regarding a distance to the sound source.

### [Advantageous Effects]

According to the aforementioned various embodiments of the present disclosure, it is possible to dynamically process audio signals according to the electronic device and the acoustic environment surrounding the electronic device, thereby enabling a more effective voice processing.

### [Description of Drawings]

The above and/or other aspects will be more apparent by describing certain exemplary embodiments with reference to the accompanying drawings, in which:
FIG. 1 is a block diagram illustrating a configuration of an electronic device according to an exemplary embodiment;
FIG. 2 is a block diagram illustrating a configuration of an electronic device according to another exemplary embodiment;
FIGS. 3A, 3B, 3C, 3D and 3E are views of an electronic device according to an exemplary embodiment;
FIG. 4 is a flowchart of an audio processing method of an electronic device according to an exemplary embodiment; and
FIG. 5 is a flowchart of an audio processing method of an electronic device according to another exemplary embodiment.

### [Mode for Invention]

Hereinafter, any specific description of a related art that is regarded to possibly obscure the substance of the present disclosure is omitted. Furthermore, the suffix "unit" combined with a component of the present disclosure is used only for convenience sake, and not for any intention to differentiate it from the component.

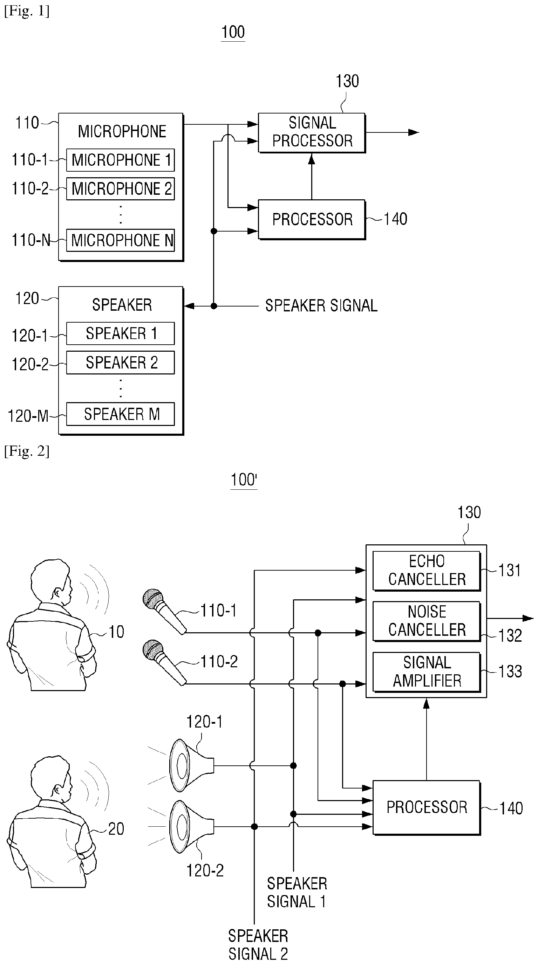

Hereinafter, various exemplary embodiments will be explained with reference to the drawings. FIG. 1 is a block diagram illustrating a configuration of an electronic device according to an embodiment of the present disclosure. According to FIG. 1, the electronic device 100 may include at least one microphone 110, at least one speaker 120, a signal processor 130, and a processor 140.

Examples of the electronic device 100 may include a television (TV), a mobile phone, a personal digital assistant (PDA), a sound bar, an electronic picture frame, an electronic bulletin board, an electronic table, a large format display (LFD), a table display, a desk top personal computer (PC), a notebook, a set top box, a smart home appliance device, or a multichannel speaker and the like, but are not limited thereto. Thus, any other system that is equipped with at least one microphone 110 and at least one speaker 120 and that requires an audio signal being output from the microphone 110 may be used to embody the electronic device 100.

The microphone 110 may convert external sound into electrical audio signals and output the electrical audio signals. In this case, there may be at least one microphone 110 such as a microphone 1 110-1, a microphone 2 110-2, and a microphone N 110-N as illustrated in FIG. 1, each of which may receive sound generated from at least one sound source from outside of the electronic device 100, convert the received sound into an audio signal, and output the converted audio signal to the signal processor 110 and the processor 140.

The speaker 120 may convert electrical speaker signals into sound and outputs the electrical speaker signals. In this case, there may be at least one speaker such as speaker a 120-1, speaker 2 120-2, and speaker M 120-M as illustrated in FIG. 1. In this case, at least one speaker may receive its corresponding speaker signal and output the speaker signal outside the electronic device 110.

Each of the speaker 1 120-1 to the speaker M 120-M may correspond to each of M speaker channels, but embodiments are not limited thereto.

The signal processor 130 may process the audio signals being output from the microphone 110. Specifically, the signal processor 130 may receive the audio signals being output from the microphone 110 and the speaker signals being input into the speaker 120 and perform various signal processing operations on those signals.

For example, the signal processor 130 may perform an 'Acoustic Echo Cancellation' operation of cancelling an echo signal drawn into the microphone 110 from the output of the speaker 120, a "Beam-forming and Noise Cancellation' operation of cancelling interference signals other than the voice of a main speaking person from a plurality of sound sources from outside, and a signal amplifying operation of amplifying audio signals and the like.

Especially, as will be explained hereinafter in more detail, the signal processor 130 may change a processing operation on the audio signals upon being controlled by the processor 140.

As aforementioned, the audio signals processed in the signal processor 130 may be transmitted to a voice recognition system that is provided inside or outside the electronic device 100 so that it can be used in voice recognition, or may be transmitted to a counterpart of a telephone call.

The processor 140 may analyze the speaker signals being input into the speaker 120 to determine information on the output of the speaker 120, and analyze the audio signals being output from the microphone 110, and determine information on the sound source being input into the microphone 110.

Specifically, the processor 140 may compute an energy value for each of the speaker signals, and use the computed energy value to determine the information on the output of the speaker 120. Furthermore, the processor 140 may determine the information on the sound source using a phase difference between each of the audio signals being output from the microphone 110.

In this case, the processor 140 may determine the information on the output of the speaker 120 by analyzing the speaker signals being input into the speaker 120 at every frame, and/or determine the information on the sound sources by analyzing the audio signals being output from the microphone 110 at every frame. Alternatively, the processor 140 may determine the information on the output of the speaker 120 and the information on the sound sources by analyzing the speaker signals being input into the speaker 120 and the audio signals being output from the microphone 110 at every predetermined frame unit.

Examples of the information on the output of the speaker 120 may include information on whether there is an output from each of at least one speaker 120, information on the number of channels of the speaker 120, information on a volume of each speaker 120, and linearity information of a transfer function between the speaker 120 and the microphone 110, but are not limited thereto.

Furthermore, examples of the information on the sound sources may include information on the number of sound sources (number of configurations) from outside the electronic device 100, direction information or angle information of the sound sources based on the location of the electronic device 100, and information on the distance from the sound sources, etc., but embodiments are not limited thereto.

The processor 140 may control the audio signal processor 130 to process the audio signals according to at least one of the information on the output of the speaker 120 and the information on the sound sources determined as mentioned above.

Specifically, the processor 140 may control the signal processor 130 to change the intensity of cancellation of echo signals included in the audio signals according to the information on the output of the speaker 120, and/or control the signal processor 130 to change the intensity of cancellation of noise, extent of beam-forming, direction of beam-forming, and extent of amplification of the audio signals according to the information on the sound sources.

In this case, the processor 140 may take various measures to have the signal processor 130 process the audio signals according to the determined information on the output of the speaker and the determined information on the sound sources.

For example, the processor 140 may provide only the information on the output of the speaker 120 or the information on the sound sources to the signal processor 130, and then the signal processor 130 may change a processing logic (for example, the number of filter bands) or change parameter values (for example, intensity of echo cancellation, intensity of noise cancellation, and/or extent of signal amplification) being used, according to the provided information. According to an exemplary embodiment, the processor 140 may itself compute parameter values being used in the signal processor 130 according to the information on the output of the speaker 120 or the information on the sound sources and apply the parameter values to the signal processor 130 or change the processing logic of the signal processor 130.

Hereinafter, operations of the electronic device according to an exemplary embodiment will be explained in further detail with reference to FIG. 2. Hereinafter, any characteristic that is repetitive of those mentioned with reference to FIG. 1 is omitted.

FIG. 2 is a block diagram illustrating the configuration of the electronic device according to an exemplary embodiment. Referring to FIG. 2, the electronic device 100 includes the microphone 1 110-1, microphone 2 110-2, speaker 1 120-1, signal processor 130, and processor 140.

The signal processor 130 includes an echo canceller 131, a noise canceller 132, and a signal amplifier 133. The signal processor 130 may perform various types of processing operations such the acoustic echo cancellation, noise cancellation, and signal amplification, etc. on the audio signals being output from the microphones 110-1 and 110-2. For this purpose, the echo canceller 131, the noise canceller 132, and the signal amplifier 133 of the signal processor 130 may include various filters and/or amplifiers, etc.

In this case, as illustrated in FIG. 2, not only the voice of the main speaking person 10 that is a processing target, but also the voice of an interfering speaking person 20 that needs to be attenuated or cancelled in the process. The sound being output from the speakers 120-1 and 120-2 may be drawn into the microphones 110-1 and 110-2 as illustrated in FIG. 2, and the microphones 110-1 and 110-2 may convert all these input sounds into audio signals and output the audio signals to the signal processor 130, and the signal processor 130 may perform various processing operations on the audio signals.

The echo canceller 131 may cancel an echo signal, which is generated as the output of the speakers 120-1 and 120-2 and then drawn into the microphones 110-1 and 110-2, from the audio signals being output from the microphones 110-1 and 110-2.

Specifically, the echo canceller 131 may also receive a speaker signal being input into the speakers 120-1 and 120-2, and cancel the echo signal using the received speaker signal (speaker signals 1 and 2 in the example of FIG. 2).

The echo canceller 131 may be controlled by the processor 140 to change a processing parameter value such as the intensity of echo cancellation, etc. in real time, and perform the echo cancellation according to the changed parameter value.

The noise canceller 132 may perform at least one of a noise cancellation and a beam-forming on the audio signals being output from the microphones 110-1 and 110-2.

The noise cancellation is a process for cancelling the noise near the microphones 110-1 and 110-2 and/or circuit noise, etc. besides the voice of the speaking persons 10 and 20, whereas the beam-forming is a process for cancelling the voice of the interfering speaking person 20 while emphasizing the voice of the main speaking person 10.

For this purpose, the noise canceller 132 may perform the noise cancellation and/or the beam-forming based on a voice separating technique of separating voice and non-voice from the audio signal, or the beam-forming technique of emphasizing the audio signal corresponding to the voice of a certain speaking person.

The noise canceller 132 may be controlled by the processor 140 to change the processing parameter value such as the intensity of the noise cancellation, etc. in real time, and perform the noise cancellation according to the changed parameter value.

The signal amplifier 133 may amplify the audio signals being output from the microphones 110-1 and 110-2. Specifically, the signal amplifier 133 may amplify the signals processed in the echo signal processor 131 or the noise canceller 132.

Especially, the signal amplifier 133 may be controlled by the processor 140 as will be explained later so as to change the processing parameter value such as the extent of amplification, etc. in real time, and amplify the input signal according to the changed parameter value.

According to an exemplary embodiment, the audio signals being output from the microphones 110-1 and 110-2 may first go through the echo cancellation operation, followed by the noise cancellation to be performed on the signals from which echo signals have been cancelled, finally followed by the amplification on the signals from which noise has been cancelled. However, the order of processing the audio signals output from the microphones 110-1 and 110-2 by the signal processor 130 is not limited to the above.

The processor 140 may determine the information on the output of the speakers 120-1 and 120-2 by analyzing the speaker signals being input into the speakers 120-1 and 120-2, and determine the information on the sound sources being input into the microphones 110-1 and 110-2 by analyzing the audio signals being output from the microphones 110-1 and 110-2.

Specifically, the processor 140 may compute the energy value of speaker signal 1 being input into the speaker 1 120-1 and the energy value of speaker signal 2 being input into the speaker 2 120-2 at a predetermined frame unit, and determine the information on the output of the speakers 120-1 and 120-2 based on the computed energy values.

For example, the processor 140 may determine whether there is an output from each of the speakers 120-1 and 120-2 by determining whether an average energy of the speaker signals during a predetermined period of time is zero (0). That is, the processor 140 may compute the energy value of each of the speaker signal 1 and the speaker signal 2 at every frame, compute the average energy value of a predetermined number of frames to compute the average energy value of the speaker signals during the predetermined period of time. If the resulting average energy value computed as aforementioned is zero (0), it may be determined that there is no output from that particular speaker. Alternatively, it may be determined that there is no output from a particular speaker if the computed average energy value is equal to or less than a predetermined value.

Furthermore, the processor 140 may determine the information on the number of channels of the speaker 120. Specifically, since the number of channels is related to the number of speakers outputting signals, if, for example, there was an output from both the speaker 1 120-1 and the speaker 2 120-2 at first and then there was no output from the speaker 2 120-2 at a certain time point, it may be determined that the number of channels has changed from two to one. In this way, the processor 140 may determine the information on the number of channels of the speaker 120 in real time.

Furthermore, the processor 140 may determine information on the volume of at least one speaker 120. In this case, the volume information refers to information on the level of output from each of the speakers 120-1 and 120-2. Specifically, the processor 140 may determine in real time the volume information of each of the speakers 120-1 and 120-2 based on the energy values of each of the speakers 120-1 and 120-2 computed at every frame.

Furthermore, the processor 140 may determine linearity information of a transfer function of the speaker 120 and the microphone 110. In this case, the transfer function of the speaker 120 and the microphone 110 may be the ratio of the level of the echo signal being drawn into the microphone 110 to the level of output. Generally, such a transfer function has linearity when the output level of the speaker is low, but has nonlinearity when the output side of the speaker rises above a certain level. Therefore, the processor 140 may determine the linearity information of the transfer function of the speaker 120 and the microphone 110 by determining whether the energy value of each of the speakers 120-1 and 120-2 computed at every frame is or above the predetermined value.

Furthermore, the processor 140 may determine the information on the sound sources of the sound being input into the microphones 110-1 and 110-2 using the phase difference between each of the audio signals being output from the microphones 110-1 and 110-2.

For example, assuming that there is the main speaking person 10, the interfering speaking person 20, and vehicle noise as sound sources from outside, the sound generated from each sound source will be drawn into each of the microphones 110-1 and 110-2 via different paths. Accordingly, the processor 140 may compute the phase difference between each audio signal being output from each of the microphones 110-1 and 110-2, and determine the angle information of each sound source, direction information of each sound source, information on the number of components of each sound source, and motion information of each sound source, etc., using the computed phase difference.

Furthermore, the processor 140 may determine the number of components of voice sound sources and non-voice sound sources from among a plurality of sound sources. For example, using a voice detection module, the processor 140 may determine that there are two voice sound sources in the aforementioned example where there are the main speaking person 10, the interfering speaking person 20 and vehicle noise).

Once each sound source is differentiated using the phase difference between the audio signals as aforementioned, the processor 140 may compute the energy level of the audio signal corresponding to each differentiated sound source, and determine the distance from each sound source based on the computed energy level.

In this case, the processor 140 may determine the information on the sound sources by analyzing the audio signals being output from the microphones 110-1 and 110-2 in a predetermined frame unit. For example, the processor 140 may determine the information on the sound sources at every frame.

The processor 140 may control the signal processor 130 to process the audio signals being output from the microphones 110-1 and 110-2 according to the information on the output of the speakers 120-1 and 120-2 and/or the information on the sound sources.

Specifically, the processor 140 may control the echo canceller 131 to change the intensity of the echo cancellation according to the information on the output of the speakers 120-1 and 120-2.

For example, in the case where the output of the speakers 120-1 and 120-2 is below a predetermined level, the processor 140 may control the echo canceller 131 not to perform the echo cancellation. That is, if both of the average energy values of the speaker signal 1 and speaker signal 2 computed as aforementioned are 0 or below the predetermined level, it may be determined that there is no output from the speakers 120-1 and 120-2, and thus the processor may control the echo canceller 131 not to perform the echo cancellation when it is determined that there is no output from the speakers 120-1 and 120-2. This is because when there is no output and/or the average energy value is below a certain level, it is better not to perform the echo cancellation operation if one is to minimize the distortion on the audio signals corresponding to the voice of the main speaking person 10.

Furthermore, the processor 140 may control the echo canceller 131 to change the intensity of the echo cancellation according to the information on the number of channels. For example, as the number of channels increases, the processor 140 may increase the intensity of the echo cancellation. This is because, if there are more channels, more echo signals will be drawn from the speakers 120-1 and 120-2 to the microphones 110-1 and 110-2.

Furthermore, the processor 140 may control the echo canceller 131 to change the intensity of the echo cancellation according to the volume information. For example, as the volume level increases, the processor 140 may increase the intensity of the echo cancellation. That is because, since the volume information represents the output level of the speakers 120-1 and 120-2, if the volume level increases, the output level will increase as well, thereby increasing the echo signals being drawn from the speakers 120-1 and 120-2 to the microphones 110-1 and 110-2.

Furthermore, the processor 140 may control the echo canceller 131 to change the intensity of the echo cancellation according to the linearity information of the transfer function of the speakers 120-1 and 120-2 and the microphones 110-1 and 110-2. For example, as the extent of linearity of the transfer function decreases, the processor 140 may increase the intensity of the echo cancellation. This is because, as the output of the speakers 120-1 and 120-2 increases, the extent of linearity will decrease, thereby drawing more echo signals from the speakers 120-1 and 120-2 to the microphones 110-1 and 110-2.

The echo canceller 131 may change the intensity of the echo cancellation by changing the signal processing logic. For example, the echo canceller 131 may change the number of the filter bands and/or change the cancellation intensity parameter value, according to the control by the processor 140.

The processor 140 may control the noise canceller 132 to change the intensity of noise cancellation or the beam-forming direction according to the information on the sound sources.

For example, in the case where there is only one sound source, the processor 140 may control the noise canceller 132 not to perform the noise cancellation. That is, when the sound source from outside is changed from three sound sources: the main speaking person 10, the interfering speaking person 20, and the vehicle sound to only one sound source: the main speaking person 10, there is no more sound source to be separated or cancelled, and thus the processor 140 may control the noise canceller 132 not to perform the noise cancellation.

Furthermore, when the number of components of non-voice sound sources decreases from among the plurality of sound sources, the processor 140 may control the noise canceller 132 to lower the intensity of the noise cancellation. Since non-voice is regarded as noise during voice recognitions and telephone calls, the processor 140 may control the noise canceller 132 to lower the intensity of the noise cancellation in accordance with the reduction of noise .

Furthermore, the processor 140 may control the noise canceller 132 to change the beam-forming direction according to the angle information or the direction information of each sound source. For example, when there is a motion in the position of the main speaking person 10 while the beam-forming is being made to the main speaking person 10, the processor 140 may control the noise canceller 132 to change the direction of the beam-forming such that the beam-forming is performed in accordance with the moved position of the main speaking person 10.

The processor 140 may control the signal amplifier 133 to change the extent of amplification of the audio signals according to the distance to the sound sources. For example, in the case where the distance from the electronic device 100 or the microphones 110-1 and 110-2 to the main speaking person 10 decreases, the processor 140 may control the signal amplifier 130 to reduce the extent of amplification of the audio signals, and in the case where the distance from the electronic device 100 or the microphones 110-1 and 110-2 to the main speaking person 10 increases, the processor 140 may control the signal amplifier 130 to increase the extent of amplification of the audio signals.

The processor 140 may collect the audio signals being output from the microphones 110-1 and 110-2 and convert the collected audio signals into digital signals of frame units, and analyze the converted digital audio signals of frame units. The electronic device 100 may be equipped with a separate sound collector configured to collect each of the audio signals being output from the microphones 110-1 and 100-2, to convert the collected audio signals into signals of frame units, and to provide the converted signals of frame units to the processor 140.

Therefore, the processor 140 may determine the information on the sound sources by analyzing the audio signals being output from the microphones 110-1 and 110-2 in a predetermined number of frame units.

Furthermore, since the speaker signals (speaker signal 1 and speaker signal 2) being input into the speakers 120-1 and 10-2 may also be processed in frame units, the processor 140 may determine the information on the output from the speakers 120-1 and 10-2 by analyzing the speaker signals being input into the speakers 120-1 and 120-2 in the predetermined number of frame units.

In FIG. 2, it is illustrated that the signal processor 130 includes the echo canceller 131, the noise canceller 132, and the signal amplifier 133, but the arrangement may vary according to an exemplary embodiment. For example, one or more of the echo canceller 131, the noise canceller 132, and the signal amplifier 133 may be disposed outside the signal processor 130.

Hereinabove, it was exemplified that the determination on the information on the output from the speakers 120-1 and 120-2 and the information on the sound sources are carried out by the signal processor 130 and a separate processor 140, but there is no limitation thereto. For example, the echo canceller 131, the noise canceller 132, and the signal amplifier 133 may determine the information on the output of the speakers 120-1 and 120-2 and the information on the sound sources and the signal processing operation may be changed based on the determined information.

For another example, the echo canceller 131 may determine the information on the output of the speakers 120-1 and 120-2 by analyzing the speaker signals and the audio signals being output from the microphones 110-1 and 110-2, and the intensity of the echo cancellation may be changed accordingly. Also, the noise canceller 132 or the signal amplifier 133 may determine the information on the audio signals being output from the microphones 110-1 and 110-2 by analyzing the audio signal being output from the microphones 110-1 and 110-2, and the intensity of the noise cancellation or the extent of the signal amplification may be changed accordingly.

However, rather than having each component of the signal processor 130 to determine the information by analyzing the speaker signals and the audio signals, and change the signal processing accordingly, it may be preferable to use a separate processor 140 for the sake of easy debugging in case of an erroneous operation and stable system.

Although it was illustrated with reference to FIGs. 1 and 2 that the electronic device 100 is embodied as one device, but there is no limitation thereto. For example, the components of the electronic device 100 may be embodied in separate devices, and may be interconnected in an entire system via wireless/wired connection.

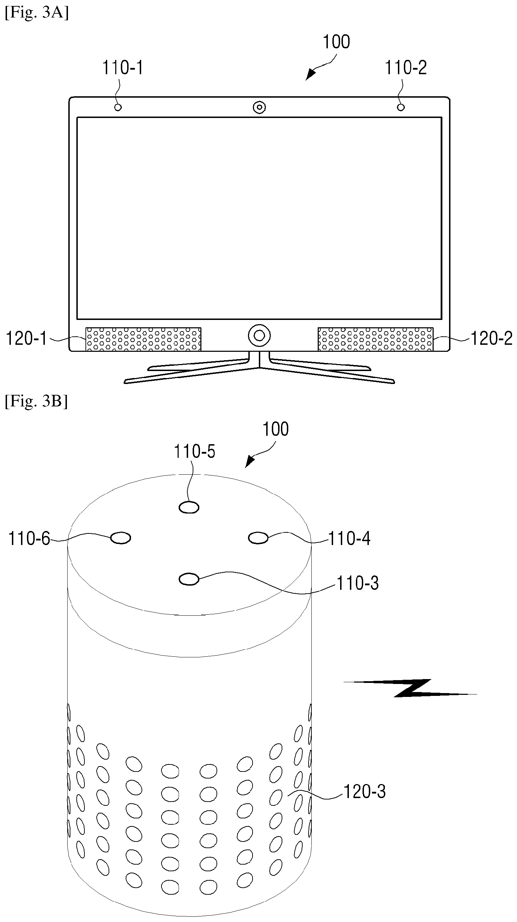

FIG. 3A is an exemplary view of the electronic device according to an exemplary embodiment. Specifically, as illustrated in FIG. 3A, the electronic device 100 may be embodied as a display device such as a TV. In this case, the TV includes two microphones 110-1 and 110-2, and two speakers 120-1 and 120-2. The TV may further include a voice recognition system and/or voice/video telephone call system.

When a user manipulates the TV through voice recognition while contents is being reproduced from the TV, a processor of the TV may control the signal processor 130 to determine the information on the output of the speakers 120-1 and 120-2 and the information on the sound sources. As aforementioned, such information may be obtained by analyzing the audio signals corresponding to each speaker signal being input into the speakers 120-1 and 120-2 and the uttered voice of the user input through the microphones 110-1 and 110-2, the output of the speakers 120-1 and 120-2, and various noises, etc. The controller may control the signal processor 130 to process the audio signals according to the determined information.

Accordingly, it is possible to dynamically process the audio signals according to the surrounding acoustic environment, thereby increasing the precision of voice recognition. Not only that, it is possible to deliver the user's voice being input into the microphones 110-1 and 110-2 more precisely even when the user is having a voice or video telephone call through the TV.

FIG. 3B illustrates an electronic device 100 according to another exemplary embodiment. In the example of FIG. 3B, the electronic device 100 is equipped with at least one speaker 120-3 and a plurality of microphones 110-3, 110-4, 110-5, and 110-6. Furthermore, the electronic device 100 of FIG. 3B is connected to an external device wirelessly in Bluetooth method and the like, and thus audio contents may be reproduced, telephone calls may be made with a counterpart through the external device, and/or the user may control the external device with voice by uttering a manipulation command.

Even in such a speaker system, the audio signals may be processed dynamically according to the surrounding acoustic environment because the technical concept of the present disclosure of enabling effective voice processing may be directly applied thereto. As a result, it is possible to manipulate the external device and/or communicate with the counterpart more precisely.

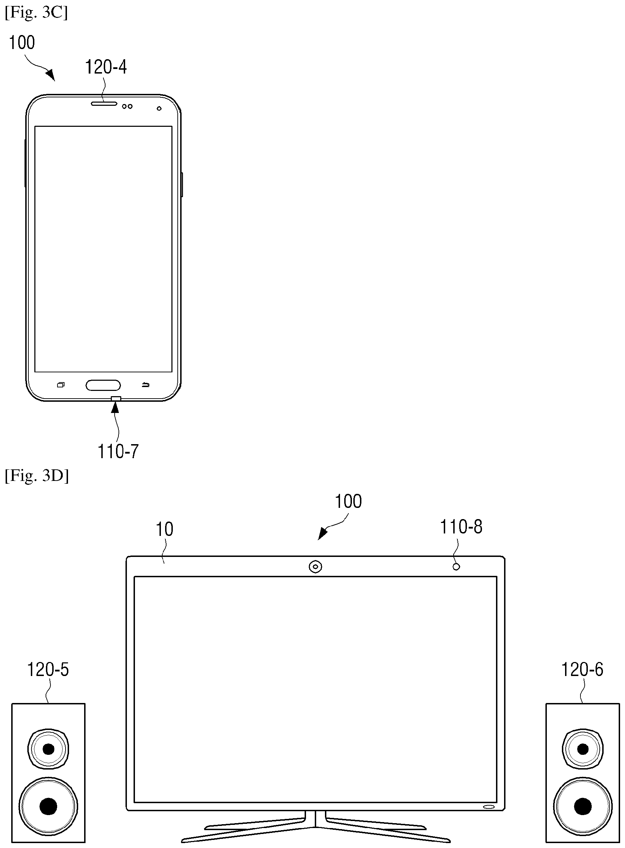

FIG. 3C is a view illustrating a mobile phone as an example of the electronic device 100 that includes one microphone 110-7 and one speaker 120-4. As illustrated, the technical concept of the present disclosure may be applied directly to a system including only one microphone 110-7 and one speaker 120-4.

Specifically, even when the system includes only one microphone 110-7, since the processor 140 may determine the distance to the external sound source through the energy level of the external sound source being input through the microphone 110-7, it is possible to control the signal amplifier 133 to change the extent of audio signal amplification according to the determined distance to the sound source.

Furthermore, even when the system includes only one speaker 120-4, since the processor 140 may determine at least one of the information on whether there is output from the speaker 120-4, information that there is one channel, volume information, and linearity information of the transfer function between the speaker 120-4 and the microphone 110-7. The processor 140 may control the operations of the echo canceller 131 and the noise canceller 132 according to the determined information on the output from the speaker 120-4.

There is no limitation to the types of electronic devices to which the inventive concept of the present disclosure may be applied. The present disclosure may be applied to any audio processing system equipped with at least one microphone and at least one speaker.

FIG. 3D is an exemplary view of an AV system 100 that includes one microphone and a plurality of speakers according to an exemplary embodiment. For example, the user may connect two speakers 120-5 and 120-6 to a monitor-integrated type PC 10 equipped with one microphone 110-8.

In this case, there may be a situation where the user performs a telephone call or a video call through the PC 10 or controls the PC 10 with voice while listening to stereo music through two speakers 120-5 and 120-6.

In this case, , the processor 140 may control the signal processor 130 to determine the information on the output of the speakers 120-5 and 120-6 by analyzing the speaker signals being input into the speakers 120-5 and 120-6, and determine the information on the sound sources (e.g., information on the distance to the sound sources) by analyzing the audio signals being output from the microphone 110-8. Then, the processor 140 may control the signal processor 130 to process the audio signals according to at least one of the determined information on the output of the speakers 120-5 and 120-6 and the determined information on the sound sources, thereby enabling a more effective voice processing operation.

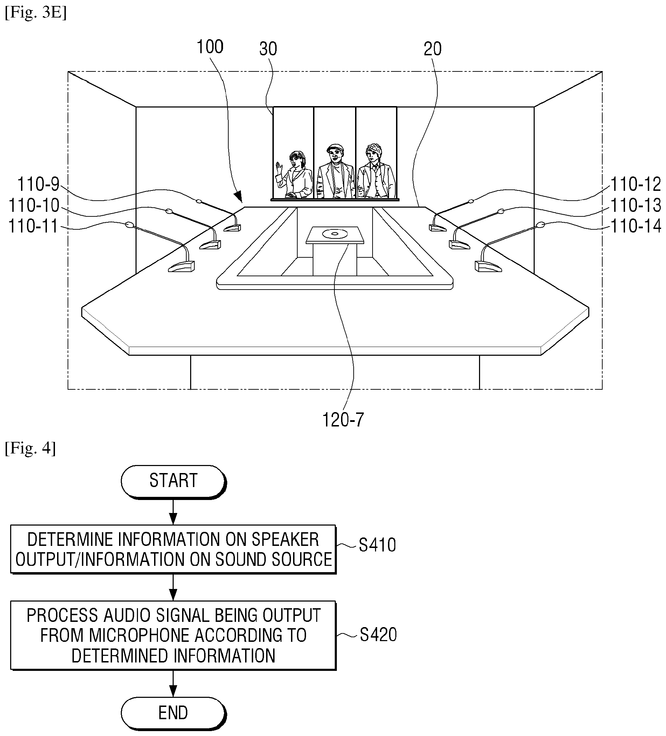

FIG. 3E is a view illustrating a video conference system 100 that includes a plurality of microphones and one speaker according to an exemplary embodiment. According to FIG. 3E, the video conference system 100 may include one speaker 120-7 and six microphones 110-9 to 110-14.

In such a situation, if a plurality of users intend to have a conference with a counterpart through a projector screen 30, the processor 140 may dynamically perform the audio signal processing operation using the information on the output of the speaker and the information on the sound sources being determined in real time, thereby enabling a good quality call.

As described with reference to FIGs. 3A to 3E, the inventive concept of the present disclosure may be applied to a device or system consisting of one microphone and one speaker, a device or system consisting of one microphone and a plurality of speakers, a device or system consisting of a plurality of microphones and one speaker, and/or a device or system consisting of a plurality of microphones and a plurality of speakers.

FIG. 4 is a flowchart of an audio processing method of the electronic device according to an exemplary embodiment. As illustrated in FIG. 4, the electronic device 100 may determine the information on the output of the speaker by analyzing the speaker signals being input into at least one speaker and determine the information on the sound sources being input into at least one microphone by analyzing the audio signals being output from the microphone (S410).

The information on the output of the speaker may be at least one of whether there is output of at least one speaker, information on the number of channels, volume information and linearity information on the speaker and the microphone. The information on the sound sources may be at least one of information on the number of the sound sources, direction information, and information on the distance to the sound sources.

The electronic device 100 may determine the information on the output of the speaker based on the energy of each speaker signal, and determine the information on the sound sources using the phase difference of each audio signal being output from the microphone.

The electronic device 100 may determine the information on the output of the speaker and the information on the sound sources by analyzing the speaker signals being input into the speaker and the audio signals being output from the microphone in a predetermined number of frame units.

Accordingly, the device 100 may process the audio signals being output from the microphone according to at least one of the determined information on the output of the speaker and the information on the sound sources (S420).

Specifically, the electronic device 100 may cancel the echo signals caused by the output of the speaker being fed back to the microphone. In this case, the intensity of echo cancellation may be changed according to the information on the output of the speaker. For example, in the case where the output of the speaker is less than the predetermined level, the electronic device 100 may not perform the echo cancellation.

The electronic device 100 may reduce the noise by performing at least one of the noise cancellation and beam-forming regarding the audio signals being output from the microphone. In this case, at least one of the intensity of the noise cancellation and the direction of the beam-forming may be changed according to the information on the sound sources. For example, when there is only one sound source, the electronic device 100 may not perform the noise cancellation.

Furthermore, the electronic device 100 may amplify the audio signals being output from the microphone. In this case, the extent of amplification of the audio signals may be changed according to the information on the sound sources.

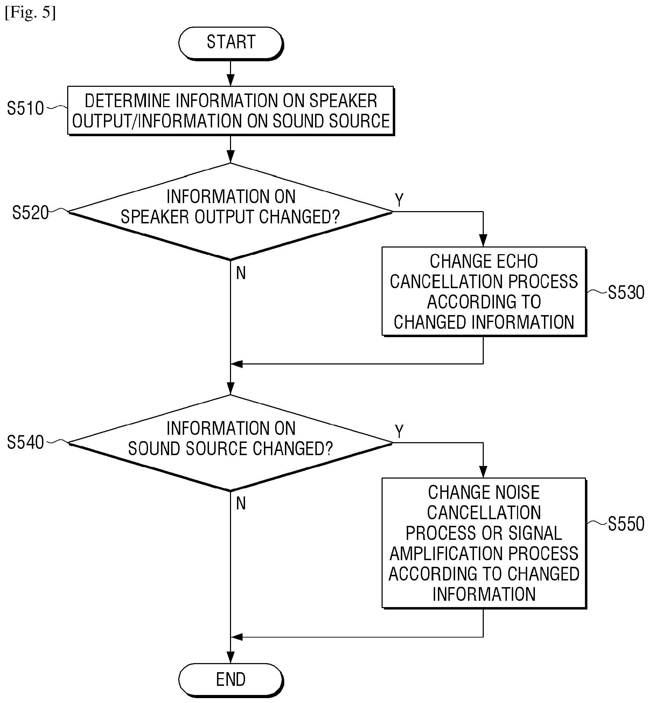

FIG. 5 is a flowchart of an audio processing method of an electronic device according to an exemplary embodiment. According to FIG. 5, the electronic device 100 may determine the information on the output of each speaker and the information on at least one sound source being input into the microphone by analyzing the speaker signals being input into at least one speaker and the audio signals being output from the at least one microphone (S510).

Accordingly, the electronic device 100 may determine whether the information on the output of the speaker is changed (S520), and if so (S520, Y), change the echo cancellation process according to the changed information on the output of the speaker and perform the changed echo cancellation process (S530).

Accordingly, the electronic device 100 may determine whether the information on the sound sources changed (S540), and if so (S540, Y), change the noise cancellation process or the signal amplification process according to the changed information on the sound sources and perform the changed noise cancellation process or the signal amplification process (S530).

According to the exemplary embodiments, it is possible to process the audio signals dynamically according to electronic device and the acoustic environment surrounding the electronic device, and thus, a more effective voice processing is possible.

Specifically, as aforementioned, a general audio processing system merely makes an initial setting of the processing parameter values such as the intensity of the echo cancellation, and then performs a consistent processing or initializes the certain filter values at a certain cycle. Therefore, if the echo cancellation is performed by a same setting when there is no or small speaker output, it is highly likely that the quality of the voice uttered by the user may deteriorate. When there is only the main speaking person without a noisy environment, the quality may deteriorate by the noise cancellation. When signal amplification is performed with a consistent value without sensing the changes in the level of the voice of the main speaking person or the distance from the main speaking person, the voice recognition performance may deteriorate or telephone call quality may deteriorate when the distance or the size of the voice changes significantly.

On the other hand, according to the exemplary embodiments, it is possible to perform the audio signal processing operation dynamically according to the changes in the acoustic environment, and thus it is possible to prevent the quality of telephone call from deteriorating even when the acoustic environment changes.

The operations of the processor 140 of the electronic device 100 or the audio processing methods of the electronic device 100 according to the exemplary embodiments may be implemented as software and be mounted onto the electronic device 100. For example, a non-transitory computer readable medium may be installed that stores a program configured to perform the audio processing method of the electronic device, the method including determining the information on the output of the speaker by analyzing the speaker signals being input into at least one speaker and determining the information on the sound sources being input into the microphone, and processing the audio signals being output from the microphone according to at least one of the determined information on the output of the speaker and the information on the sound sources

The non-transitory computer readable medium refers to a computer readable medium that is configured to store data semi-permanently and not for a short period of time such as a register, cache, memory and the like. More specifically, the various aforementioned applications or programs may be stored in and provided through a non-transitory computer readable medium such as a compact disc (CD), a digital versatile disc (DVD), a hard disc, a blue-ray disc, a universal serial bus (USB), a memory card, a read only memory (ROM) and the like.

The foregoing exemplary embodiments and advantages are merely exemplary and are not to be construed as limiting the inventive concept. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. An electronic device (100) comprising:
at least one speaker (120);
at least one microphone (110);
a signal processor (130) configured to:
process an audio signal being output from the microphone; and
a processor (140) configured to control the signal processor to determine first information regarding an output of the speaker by analyzing at least one speaker input signal being input into the speaker, and to determine
second information regarding a sound source being input into the microphone by analyzing at least one audio signal being output from the microphone, and
to process the at least one audio signal according to at least one of the first and second information, and
wherein the signal processor comprises an echo canceller configured to cancel an echo signal caused by the output of the speaker being fed back to the microphone as another microphone input sound, and **characterised in that** the processor is configured to control the echo canceller not to perform the echo cancellation when the output of the speaker is below a predetermined level.

2. The device according to claim 1, wherein the processor is configured to determine the first information based on an energy level computed for each speaker signal, and determines the second information using a phase difference between multiple audio signals.

3. The device according to claim 1,
wherein the processor is configured to control the echo canceller to change an intensity of echo cancellation according to the first information.

4. The device according to claim 1, wherein the signal processor comprises a noise collector configured to perform at least one of noise cancellation and beam-forming on the at least one audio signal, and
wherein the processor is configured to control the noise canceller to change at least one of an intensity of noise cancellation and a beam-forming direction according to the second information.

5. The device according to claim 4, wherein the processor is configured to control the noise canceller not to perform the noise cancellation when there is one sound source.

6. The device according to claim 1, wherein the signal processor comprises a signal amplifier configured to amplify the at least one audio signal, and
the processor is configured to control the signal amplifier to change an extent of amplification of the at least one audio signal according to a distance to the sound source.

7. The device according to claim 1, wherein the processor is configured to determine the first and second information by analyzing the speaker input signal and the at least one audio signal in a predetermined number of frame units.

8. The device according to claim 1, wherein the second information comprises at least one of information regarding a number of the sound source, direction information and information regarding a distance to the sound source.

9. An audio processing method of an electronic device equipped with at least one speaker and at least one microphone, the audio processing method comprising:
determining first information regarding an output of the speaker by analyzing at least one speaker input signal being input into the speaker and determining second information regarding a sound source being input into the microphone by analyzing at least one audio signal being output from the microphone; and
processing the at least one audio signal according to at least one of the first and second information,
wherein the processing comprises:
cancelling an echo signal caused by the output of the speaker being fed back to the microphone as another microphone input sound;
wherein the echo cancellation is controlled; **characterised in that**: the controlling comprises stopping the echo cancellation when the output of the speaker is below a predetermined level.

10. The audio processing method according to claim 9, wherein the determining comprises:
determining the first information based on an energy level of the at least one speaker input signal; and
determining the second information using a phase difference between multiple audio signals.

11. The audio processing method according to claim 9 wherein the processing comprises:
changing an intensity of echo cancellation according to the first information.

12. The audio processing method according to claim 9, wherein the processing comprises:
changing at least one of an intensity of noise cancellation and a beam-forming direction according to the second information regarding the sound source.

13. The audio processing method according to claim 12, wherein the changing comprises stopping the noise cancellation when there is one sound source.

## Patentansprüche

1. Elektronische Vorrichtung (100), umfassend:
mindestens einen Lautsprecher (120);
mindestens ein Mikrofon (110);
einen Signalprozessor (130), der ausgelegt ist zum:
Verarbeiten eines vom Mikrofon ausgegebenen Audiosignals; und
einen Prozessor (140), der dazu ausgelegt ist, den Signalprozessor zu steuern, um erste Informationen bezüglich einer Ausgabe des Lautsprechers durch Analysieren mindestens eines Lautsprechereingangssignals, das in den Lautsprecher eingegeben wird, zu bestimmen, und um
zweite Informationen bezüglich einer in das Mikrofon eingegebenen Tonquelle durch Analysieren mindestens eines vom Mikrofon ausgegebenen Audiosignals zu bestimmen, und
um das mindestens eine Audiosignal gemäß mindestens einer der ersten und zweiten Informationen zu verarbeiten, und
wobei der Signalprozessor einen Echounterdrücker umfasst, der dazu ausgelegt ist, ein Echosignal zu unterdrücken, das durch die Ausgabe des Lautsprechers verursacht wird, der als ein weiterer Mikrofoneingangston zum Mikrofon zurückgeführt wird, und **dadurch gekennzeichnet, dass** der Prozessor dazu ausgelegt ist, den Echounterdrücker so zu steuern, dass er die Echounterdrückung nicht durchführt, wenn die Ausgabe des Lautsprechers unter einem vorbestimmten Pegel liegt.

2. Vorrichtung nach Anspruch 1, wobei der Prozessor dazu ausgelegt ist, die ersten Informationen basierend auf einem für jedes Lautsprechersignal berechneten Energiepegel zu bestimmen, und die zweiten Informationen unter Verwendung einer Phasendifferenz zwischen mehreren Audiosignalen bestimmt.

3. Vorrichtung nach Anspruch 1,
wobei der Prozessor dazu ausgelegt ist, den Echounterdrücker zu steuern, um eine Intensität der Echounterdrückung gemäß den ersten Informationen zu ändern.

4. Vorrichtung nach Anspruch 1, wobei der Signalprozessor einen Geräuschsammler umfasst, der dazu ausgelegt ist, mindestens eine Geräuschunterdrückung und/oder Strahlformung an dem mindestens einen Audiosignal durchzuführen, und
wobei der Prozessor dazu ausgelegt ist, den Geräuschunterdrücker zu steuern, um eine Intensität der Geräuschunterdrückung und/oder eine Strahlformungsrichtung gemäß den zweiten Informationen zu ändern.

5. Vorrichtung nach Anspruch 4, wobei der Prozessor dazu ausgelegt ist, den Geräuschunterdrücker so zu steuern, dass er die Geräuschunterdrückung nicht durchführt, wenn eine Tonquelle vorliegt.

6. Vorrichtung nach Anspruch 1, wobei der Signalprozessor einen Signalverstärker umfasst, der dazu ausgelegt ist, das mindestens eine Audiosignal zu verstärken, und
der Prozessor dazu ausgelegt ist, den Signalverstärker zu steuern, um das Ausmaß der Verstärkung des mindestens einen Audiosignals gemäß dem Abstand zur Tonquelle zu verändern.

7. Vorrichtung nach Anspruch 1, wobei der Prozessor dazu ausgelegt ist, die ersten und zweiten Informationen durch Analysieren des Lautsprechereingangssignals und des mindestens einen Audiosignals in einer vorbestimmten Anzahl von Rahmeneinheiten zu bestimmen.

8. Vorrichtung nach Anspruch 1, wobei die zweiten Informationen Informationen bezüglich einer Nummer der Tonquelle und/oder Richtungsinformationen und/oder Informationen bezüglich eines Abstands zur Tonquelle umfassen.

9. Audioverarbeitungsverfahren einer elektronischen Vorrichtung, die mit mindestens einem Lautsprecher und mindestens einem Mikrofon ausgestattet ist, wobei das Audioverarbeitungsverfahren umfasst:
Bestimmen erster Informationen bezüglich einer Ausgabe des Lautsprechers durch Analysieren mindestens eines Lautsprechereingangssignals, das in den Lautsprecher eingegeben wird, und Bestimmen zweiter Informationen bezüglich einer Tonquelle, die in das Mikrofon eingegeben wird, durch Analysieren mindestens eines Audiosignals, das von dem Mikrofon ausgegeben wird; und
Verarbeiten des mindestens einen Audiosignals gemäß mindestens einer der ersten und zweiten Informationen, wobei das Verarbeiten umfasst:
Unterdrücken eines Echosignals, das durch Rückführen des Lautsprecherausgangs zum Mikrofon als weiterer Mikrofoneingangston verursacht wird;
wobei die Echounterdrückung gesteuert wird;
**dadurch gekennzeichnet, dass**:
die Steuerung das Stoppen der Echounterdrückung umfasst, wenn der Ausgang des Lautsprechers unter einem vorbestimmten Pegel liegt.

10. Audioverarbeitungsverfahren nach Anspruch 9, wobei das Bestimmen umfasst:
Bestimmen der ersten Informationen basierend auf einem Energiepegel des mindestens einen Lautsprechereingangssignals; und
Bestimmen der zweiten Informationen unter Verwendung einer Phasendifferenz zwischen mehreren Audiosignalen.

11. Audioverarbeitungsverfahren nach Anspruch 9, wobei das Verarbeiten umfasst:
Ändern einer Intensität der Echounterdrückung gemäß den ersten Informationen.

12. Audioverarbeitungsverfahren nach Anspruch 9, wobei das Verarbeiten umfasst:
Ändern einer Intensität der Geräuschunterdrückung und/oder einer Strahlformungsrichtung gemäß den zweiten Informationen bezüglich der Tonquelle.

13. Audioverarbeitungsverfahren nach Anspruch 12, wobei das Ändern das Stoppen der Geräuschunterdrückung umfasst, wenn eine Tonquelle vorliegt.

## Revendications

1. Dispositif électronique (100) comprenant :
au moins un haut-parleur (120) ;
au moins un microphone (110) ;
un processeur de signal (130) conçu pour :
traiter un signal audio fourni en sortie par le microphone ; et
un processeur (140) conçu pour commander le processeur de signal afin qu'il détermine des premières informations concernant une sortie du haut-parleur en analysant au moins un signal d'entrée de haut-parleur fourni en entrée au haut-parleur, et pour déterminer
des secondes informations concernant une source sonore fournie en entrée au microphone en analysant au moins un signal audio fourni en sortie par le microphone, et
pour traiter ledit au moins un signal audio en fonction d'au moins l'une des premières et des secondes informations, et
dans lequel le processeur de signal comprend un suppresseur d'écho conçu pour supprimer un signal d'écho provoqué par la sortie du haut-parleur, qui est renvoyé au microphone sous la forme d'un autre son d'entrée de microphone, et **caractérisé en ce que** le processeur est conçu pour commander le suppresseur d'écho afin qu'il n'effectue pas la suppression d'écho lorsque la sortie du haut-parleur est inférieure à un niveau prédéterminé.

2. Dispositif selon la revendication 1, dans lequel le processeur est conçu pour déterminer les premières informations sur la base d'un niveau d'énergie calculé pour chaque signal de haut-parleur, et détermine les secondes informations en utilisant une différence de phase entre de multiples signaux audio.

3. Dispositif selon la revendication 1, dans lequel le processeur est conçu pour commander le suppresseur d'écho afin de modifier une intensité de suppression d'écho en fonction des premières informations.

4. Dispositif selon la revendication 1, dans lequel le processeur de signal comprend un collecteur de bruit conçu pour effectuer au moins l'une d'une suppression de bruit et d'une formation de faisceau sur ledit au moins un signal audio, et
dans lequel le processeur est conçu pour commander le suppresseur de bruit afin qu'il modifie au moins l'une d'une intensité de suppression de bruit et d'une direction de formation de faisceau en fonction des secondes informations.

5. Dispositif selon la revendication 4, dans lequel le processeur est conçu pour commander le suppresseur de bruit afin qu'il n'effectue pas la suppression de bruit lorsqu'il y a une source sonore.

6. Dispositif selon la revendication 1, dans lequel le processeur de signal comprend un amplificateur de signal conçu pour amplifier ledit au moins un signal audio, et
le processeur est conçu pour commander l'amplificateur de signal afin qu'il modifie le degré d'amplification dudit au moins un signal audio en fonction de la distance à la source sonore.

7. Dispositif selon la revendication 1, dans lequel le processeur est conçu pour déterminer les premières et secondes informations en analysant le signal d'entrée de haut-parleur et ledit au moins un signal audio dans un nombre prédéterminé d'unités de trames.

8. Dispositif selon la revendication 1, dans lequel les secondes informations comprennent au moins l'une d'informations concernant un nombre de la source sonore, des informations de direction et des informations concernant une distance à la source sonore.

9. Procédé de traitement audio d'un dispositif électronique équipé d'au moins un haut-parleur et d'au moins un microphone, le procédé de traitement audio comprenant :
la détermination de premières informations concernant une sortie du haut-parleur en analysant au moins un signal d'entrée de haut-parleur qui est fourni en entrée au haut-parleur et la détermination de secondes informations concernant une source sonore qui est fournie en entrée au microphone en analysant au moins un signal audio qui est fourni en sortie par le microphone ; et
le traitement dudit au moins un signal audio en fonction d'au moins l'une des premières et secondes informations, dans lequel le traitement comprend :
la suppression d'un signal d'écho provoqué par le fait que la sortie du haut-parleur est renvoyée au microphone sous la forme d'un autre son d'entrée de microphone ;
dans lequel la suppression d'écho est commandée ;
**caractérisé en ce que** :
la commande comprend l'arrêt de la suppression d'écho lorsque la sortie du haut-parleur est inférieure à un niveau prédéterminé.

10. Procédé de traitement audio selon la revendication 9, dans lequel la détermination comprend :
la détermination des premières informations sur la base d'un niveau d'énergie dudit au moins un signal d'entrée de haut-parleur ; et
la détermination des secondes informations en utilisant une différence de phase entre de multiples signaux audio.

11. Procédé de traitement audio selon la revendication 9,
dans lequel le traitement comprend :
la modification d'une intensité de suppression d'écho en fonction des premières informations.

12. Procédé de traitement audio selon la revendication 9, dans lequel le traitement comprend :
la modification d'au moins l'une d'une intensité de suppression de bruit et d'une direction de formation de faisceau en fonction des secondes informations concernant la source sonore.

13. Procédé de traitement audio selon la revendication 12, dans lequel la modification comprend l'arrêt de la suppression de bruit lorsqu'il y a une source sonore.
